# EUROPEAN PATENT SPECIFICATION

(11) **EP 4 390 385 B1**
(45) Date of publication and mention of the grant of the patent: **06.05.2026**
(21) Application number: 22383281.7
(22) Date of filing: 23.12.2022
(51) Int. Cl.: G01N 27/414

(54) **GRAPHENE DEVICE AND METHOD OF FABRICATION OF A GRAPHENE DEVICE**
GRAPHENVORRICHTUNG UND VERFAHREN ZUR HERSTELLUNG EINER GRAPHENVORRICHTUNG
DISPOSITIF À BASE DE GRAPHÈNE ET PROCÉDÉ DE FABRICATION D'UN DISPOSITIF À BASE DE GRAPHÈNE

(43) Date of publication of application: 26.06.2024
(73) Proprietor: Graphenea Semiconductor S.L.U., 20009 Donostia - San Sebastian, Guipuzcoa (ES)
(72) Inventor: Torres Alonso, Elías, Donostia - San Sebastián (Guipúzcoa) (ES)
(74) Representative: Balder IP Law, S.L.

(56) References cited:
- JP-A- 2018 163 146
- US-A1- 2018 321 184
- US-A1- 2018 368 743
- US-A1- 2022 136 996
- HAN SHU-JEN ET AL: "Multifinger Embedded T-Shaped Gate Graphene RF Transistors With High $f_{\rm MAX}/f_{T}$ Ratio", IEEE ELECTRON DEVICE LETTERS, IEEE, USA, vol. 34, no. 10, 1 October 2013 (2013-10-01), pages 1340 - 1342, XP011527869, ISSN: 0741-3106, [retrieved on 20130923], DOI: 10.1109/LED.2013.2276038

## Description

### TECHNICAL FIELD

The present invention relates to the field of semiconductors and electronics industry and, in particular, to solid-state devices and associated methods. More particularly, it relates to solid-state devices comprising graphene, and associated methods.

### STATE OF THE ART

Since its discovery at the beginning of the 21^{st} century, graphene has attracted much attention due to its properties, such as high electronic mobility, extraordinary thermal conductivity, great strength, flexibility and transparency. Due to these properties, many diverse uses and applications have been researched, such as transparent conductive electrodes and photoactive layers in optoelectronics, Hall-effect sensors for low-magnetic field sensing, diodes, copper interconnects replacements in Very Large Scale Integration (VLSI) semiconductor processes and biosensing, biotechnology and healthcare, to name a few.

In particular, the monolayer (atomically thin) structure of graphene allows it to be sensitive to electrostatic perturbations at its surface. The observation of this sensitivity has enabled the development of graphene-based chemical and biological sensors based on graphene solid-state devices, such as graphene field effect transistors (GFETs), whose operation is based on the change in electrical properties when exposed to a targeted chemical or biological agent. This ultra-sensitivity can be selective if the graphene is functionalized with the right molecules and bioconjugates, which act as recognition element and provide specificity to the biosensor, thus creating specific binding sites for the biomarkers of choice to be bond to. This way, when the biomarker interacts with the probe molecule, they bind, producing a change in the electronic state of the probe and linker molecule, if any. This produces a charge transfer into the graphene channel which changes its conductivity. This results in a change in the conductance of graphene and thus a change in the current flowing through the, for example, transistor, which is the output signal. Obtaining electrical readouts -versus chromatographic or optical ones- permits to benefit from well-known techniques for electrical analysis of signals. Thus, graphene sensors or graphene chips, such as chips having one or more graphene solid-state devices, have immense potential for disrupting the diagnosis -and thus healthcare- sector, among other sectors.

HAN SHU-JEN et al: "Multifinger Embedded T-Shaped Gate Graphene RF Transistors With High fMAX/fT Ratio", IEEE Electron Device letters, vol. 34, n° 10, October 2013, discloses a graphene device structure having multiple-finger T-shaped gates embedded in the substrate, which provides certain advantages in the field of RF transistors. JP2018163146A discloses a graphene-based sensor provided with a back gate electrode.

US 2018/0368743 A1 discloses a FET comprising substrate, gate electrode, and microfluidic channel including graphene, where channel is formed between drain and source electrodes. A passivation layer made from a thin polymer layer, e.g. parylene is provided.

To manufacture GFETs for biosensing, source and drain contacts are usually passivated to insulate them from the liquid analyte. This prevents, among other things, large current leakage through the sample. Passivation is achieved by applying an insulating material on top of the contacts acting as source and drain. For this passivation, different materials may be used, such as oxide dielectric materials (from now on dielectrics) and polymeric materials.

Biosensing is not the only application benefiting from this approach. Other applications in the field of photonics and optoelectronics can benefit therefrom. For instance, sensitized photodetectors with quantum dots, photosensitive polymers and perovskites, among others, can use this approach to insulate the active layer from the source and drain contacts, enhancing the photogain mechanism characteristic in these hybrid devices and thus improving responsivity of the photodetector.

An example of sensor device having passivated contacts is disclosed in US2018/0321184A1, wherein a transparent sensor device is disclosed. This device implements gate, drain and source bottom contacts, each contact being performed in separate lithographic and metallization steps. Having different metallization steps adds complexity to the manufacturing process and involves a less accurate alignment between, for example, drain and source contacts.

Therefore, there is a need to develop new methods of fabricating graphene-based devices which overcome the above-mentioned drawbacks.

### DESCRIPTION OF THE INVENTION

The present invention provides a new graphene-based solid-state device as defined in claim 6 and a new method of fabricating a graphene-based solid-state device as defined in claim 1, which overcomes the drawbacks of conventional devices and methods of fabrication of these devices. The graphene-based solid-state device has at least two top contacts. The at least two top contacts are manufactured in a same lithographic step and their corresponding metallic depositions are applied in a same metal deposition step. These contacts are therefore aligned with high accuracy. The material for one of the insulations (i.e. insulation for gate contact when the device is a GFET) is selected to be mutually exclusive with the material for other insulations (i.e. insulation for the top contacts, such as source and drain contacts when the device is a GFET). The two selected materials present good etch selectivity between them. In this way, the resulting device is not affected by imperfections in the graphene layer because the etch rate of one of the insulating materials (i.e. gate isolating material) is negligible (for example, at least five times smaller) compared with the etch rate of the material used for insulating the other contacts (i.e. source and drain). The insulation materials (i.e. gate insulation material and source and drain insulation material) are chosen to be dielectric materials selected from oxide dielectric materials or any of GaN, TaN or Si3N4.

Oxide dielectric materials or any of GaN, TaN or Si3N4 (from now on, dielectrics or dielectric materials) are preferred versus polymeric materials due to their superior chemical stability and insulating properties.

The invention provides a fabrication process of a solid-state device (also referred to as semiconductor device) comprising graphene. Solid-state devices are typically based on a semiconductor material, such as silicon, germanium, gallium arsenide or an organic semiconductor. The semiconductor conductivity can be controlled by the introduction of an electric or magnetic field, by exposure of light or heat, or by other means, so that the semiconductor material can perform as a sensor. Current flow in a semiconductor occurs due to mobility of free electrons, also called charge carriers. The graphene-based solid-state device can be any solid-state device in which the semiconductor material is graphene defining a graphene channel. The graphene-based semiconductor device to which the fabrication process of the invention is applicable is a three-terminal device, such as a transistor, or an N-terminal device. In other words, the graphene-based solid-state device is a device having at least three contacts. Non-limiting examples of graphene-based solid-state devices to which the fabrication process of the invention is applicable are: triodes, bipolar junction transistors, field-effect transistors, metal-oxide semiconductors, High-electron mobility transistors (HEMTs), thyristors, barristors, memristors, pin junctions, photodetectors, magnetoresistive devices, spin valves, spin torque devices, bolometers and hybrid transition metal dichalcogenide/graphene based heterostructures, among others. In a particular embodiment, the graphene-based solid-state device to which the fabrication process is applicable, is a GFET.

The method involves patterning metal depositions, dielectrics and graphene layers. In the context of the present invention, patterning involves stages of resist deposition, mask exposure and development. The patterns (geometric shape or profile) of the metallic, dielectric and graphene depositions to be applied to the graphene device (or rather, to the layered structure to become a graphene device) have been previously designed with computer-aided techniques, such as CAD software or the like. The computer-aided design permits to define areas or regions on the surface of the die over which metallization is to be deposited.

In a first aspect of the present invention, a method of fabricating a graphene-based solid-state device as defined in claim 1 is provided.

In embodiments of the invention, the at least one graphene channel is either deposited or grown on the substrate.

In some embodiments, the substrate is a sacrificial substrate, meaning that a graphene device may be fabricated on the sacrificial substrate and then transferred to another substrate. Any suitable substrate material may be used as sacrificial substrate, providing the substrate material is compatible with the different fabrication steps.

In embodiments of the invention, the first oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO BaO, WO3, MoO3, Sc2O3, Li2O and SrO.

In embodiments of the invention, the second oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO, provided that the second oxide dielectric material is different of the first oxide dielectric material and the selectivity to at least one etchant of the first oxide dielectric material is different from the selectivity to said at least one etchant of the second oxide dielectric material.

In embodiments of the invention, prior to disposing the at least one graphene layer on the first layer of an insulating material, the substrate is cleaned to remove impurities and increase hydrophilicity.

In embodiments of the invention, the layer of an electric conductive material and/or the at least one metallic contact are made of at least one of: Titanium (Ti), Nickel (Ni), Gold (Au), Palladium (Pd), Cobalt (Co), Chromium (Cr), Aluminum (Al), Tungsten (W), TaN, (Tantalum Nitride), TiN (Titanium Nitride), Silicon (Si), doped Silicon (doped Si), poly-silicon (poly-Si), Cobalt monosilicide (CoSi), Platinum (Pt), Copper (Cu), Silver (Ag), Lead (Pb), Iron (Fe), Co/Fe alloy, and combinations/alloys of these materials.

In a second aspect of the present invention, a graphene-based solid-state device as defined in claim 6 is provided.

In embodiments of the invention, the first oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO.

In embodiments of the invention, the second oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO, provided that the second oxide dielectric material is different of the first oxide dielectric material and the selectivity to at least one etchant of the first oxide dielectric material is different from the selectivity to said at least one etchant of the second oxide dielectric material.

The fabrication techniques disclosed so far can be used, for example, to fabricate one or more GFETs, in which a suitable voltage may be applied to the back gate contact to bias electrical properties of the graphene channel, so that the GFET can be used as a sensor of electrical activity in a cell culture or as a chemical sensor, for example. In some embodiments, a single (global) back gate may be disposed under a plurality of GFETs disposed on a same die and may be used to bias all the GFETs. In some embodiments, different (local) back gates may be disposed under different subsets of GFETs and may be used to selectively bias different subsets of GFETs. In some embodiments, each GFET in a die has a corresponding back gate, independent from the back gates of the other GFETs of the die.

The proposed method and architecture enable to obtain a semi-encapsulated device (encapsulated by the second insulation layer except for the exposed back gate contact and graphene channel) having a back (bottom) gate and top contacts. This is achieved thanks to the abovementioned selection of dielectric (insulating) materials. The architecture also enables the back gate to be local. All this is achieved in a single fabrication process.

The graphene device may be used as a sensor device, or a plurality of graphene devices belong to a sensor device. In embodiments of the invention, the die or wafer 10 comprises a plurality of graphene devices. For example, a sensor having a plurality of graphene devices can be implemented in a single die.

In this case, in some embodiments, the sensor device comprises at least one probe molecule bonded to the one or more graphene devices, for example GFETs, such that if the at least one probe molecule is exposed to a biological sample comprising a biomarker while a voltage is applied to the GFETs, the conductance of the GFETs changes. In embodiments of the invention, the at least one probe molecule is bonded to the GFETs through a linker molecule, such that if the probe is exposed to a biological sample (blood, urine, saliva, serum, etc.) containing the biomarker in a liquid medium while voltage is applied to the GFETs, the conductance of the GFETs changes as a consequence of the reaction between the probe molecule and the biomarker. The biomarker may be an antibody, an enzyme, a protein, a virus, an antigen, a pathogen, or a volatile organic compound, among others. The probe molecule may be an antibody, an enzyme, a protein, a virus, an antigen, a pathogen, etc. The linker molecule may be an organic molecule containing aromatic molecules having a non-covalent link to the graphene or an organic molecule having a covalent link to the graphene. The linker has a functional group for anchoring or attaching the probe molecule. Suitable functional groups include amino, thiol, activated esters, carboxy, etc. Specially interesting are activated esters such as N-hydroxysuccinimide esters for the modification of amino groups present in proteins, antibodies, viruses, etc.

In some embodiments, the sensor device comprises at least one quantum dot (QDs) deposited on the top of the graphene channel. These QDs can be tailored, both in material and size, to emit and absorb light in a specific wavelength. The latter effect can be used to create highly responsive photodetectors to a certain wavelength, due to the increased absorption of the QDs in that wavelength range. Moreover, because the contacts are passivated, the QDs will be in contact only with the graphene layers. The electron-hole pair created upon absorption will be split by the in-built electric field created by the difference in electron work functions between the QDs and the graphene layer. Because of the high difference in electron mobilities and lifetimes between the hole and electrons in the QDs and the graphene respectively, the electron will recirculate through the channel in graphene, creating a gain effect which dramatically improves the responsivity of the photodetector. The QDs can be made of inorganic materials, such as InAs, InSb, Ge, InP, ZnSe, ZnO, ZnS, CZTS, Cu₂S, Bi₂S₃, Ag₂S, HgTe, CdSe, CdHgTe, CdS, PbSe, PbS, CIS and combinations of them and/or core-shell type of arrangements. They can also be made of inorganic materials such as graphene quantum dots, fullerenes, and different polymers. They can also be made out of perovskites, which have the octahedral structure ABX3 with halogens on the corner (X: Cl, Br or I); transition metals in the centre (B: Pb or Sn) and cations in between octahedral (A: Cs, organic FA (formamidinium CH(NH₂)₂) or MA (methylammonium CH₃NH₃)).

Additional advantages and features of the invention will become apparent from the detailed description that follows and will be particularly pointed out in the appended claims.

### BRIEF DESCRIPTION OF THE DRAWINGS

To complete the description and to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1A and 1B respectively illustrate a top view and a cross-section view of a back contact layer deposited on a substrate according to embodiments of the present invention.
Figures 2A and 2B respectively illustrate a top view and a cross-section view of a back insulating layer deposited on the stack formed by the back contact layer and substrate, according to embodiments of the present invention.
Figures 3A and 3B respectively illustrate a top view and a cross-section view of stages involving the patterning of the back insulating layer, according to embodiments of the present invention.
Figures 4A and 4B respectively illustrate a top view and a cross-section view of a graphene layer deposited on the back insulating layer, according to embodiments of the present invention.
Figures 5A and 5B respectively illustrate a cross-section view and a cross-section view of electric contacts deposited on defined positions of the graphene layer, according to an embodiment of the present invention.
Figures 6A and 6B respectively illustrate a top view and a cross-section view of a second insulating layer deposited on the device stack, according to an embodiment of the present invention.
Figures 7A and 7B respectively illustrate a top view and a cross-section view of the manufacturing process once the second insulating layer is selectively etched to expose the graphene layer, according to an embodiment of the present invention.

### DESCRIPTION OF A WAY OF CARRYING OUT THE INVENTION

The following description is not to be taken in a limiting sense but is given solely for the purpose of describing the broad principles of the invention. Next embodiments of the invention will be described by way of example, with reference to the above-mentioned drawings showing apparatuses and results according to the invention.

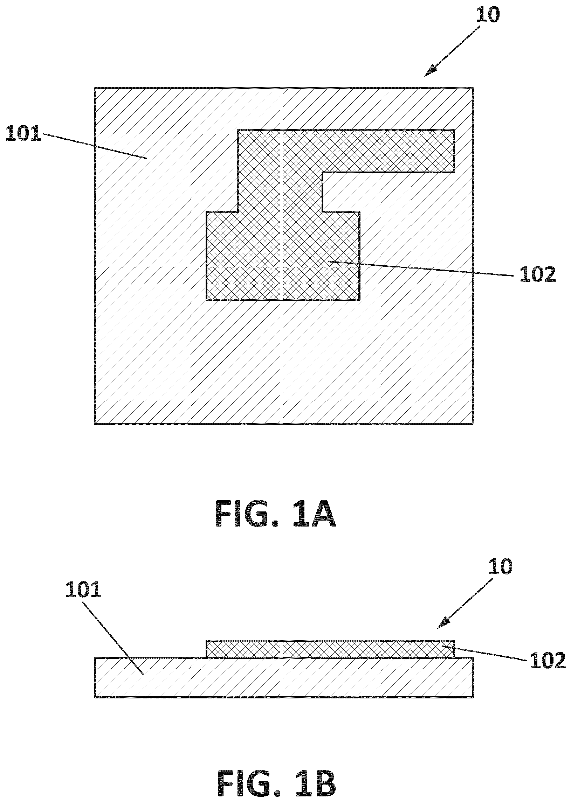

Figures 1A to 6B schematically represent the fabrication process of a solid-state device comprising graphene implemented in an electronic die or wafer 10, according to embodiments of the invention. Figures labelled as "A" (1A, ..., 6A) represent top views of different fabrication stages, while figures labelled as "B" (1B, ..., 6B) represent cross-section views of the different fabrication stages.

In accordance with some embodiments of the invention, a solid-state device comprising graphene (from now on, a graphene device) is provided. In particular, the fabrication process of a graphene FET (GFET) is explained in detail next. One skilled in the art will understand that the disclosed fabrication process is applicable to other graphene devices having at least three terminals.

Referring to Figures 1A-1B, in accordance with embodiments of the invention, a substrate 101 compatible with the different steps for fabricating a graphene device, is provided. The substrate 101 may be rigid or flexible. The substrate 101 can be made of glass, quartz, Si, SiO2/Si, SiO2, Al2O3, hBN, ZrO2, HfO2, HfSiO4, Ta2O5, La2O3, LaAlO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O, SrO, or any combination of these materials. In embodiments of the invention, the substrate may be formed by two layers (upper layer and lower layer). The lower layer may be made of one of silicon, silicon oxide, glass, quartz and polymeric material. The higher layer may be made, for example, of glass, quartz, Si, SiO2/Si, SiO2, Al2O3, ZrO2, HfO2, HfSiO4, Ta2O5, La2O3, LaAlO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O or SrO. For example, the substrate may be formed by a silicon dioxide layer deposited on a silicon substrate layer, in turn obtained from doped silica (n++Si).

A back contact layer or bottom contact layer 102 (a back gate layer in the case of a GFET) is deposited on the substrate 101. The back contact layer 102 is intended to become a back contact (for example, a back gate contact) in the manufactured device. The back contact layer 102 is made of an electric conductive material, so that the subsequent back contact enables the flow of electric current. It acts as local gate contact. The back contact layer 102 is preferably metallic. Non-limiting examples of metals used for the back contact layer 102 are: Au, Ti, W, Cr, Ni, Al, Cu, Pd, Pt, Co, Fe, poly-Si, doped-Si, Bi, Nb, Ag, Zn, TiN and combinations of them. The back contact layer 102 may be deposited using a suitable deposition method, such as electron beam (ebeam) deposition, sputter deposition, thermal evaporation, electrodeposition or electroplating. The thickness of this layer 102 may be from several nanometers (for example, from 1nm) to several microns (for example, to 100µm).

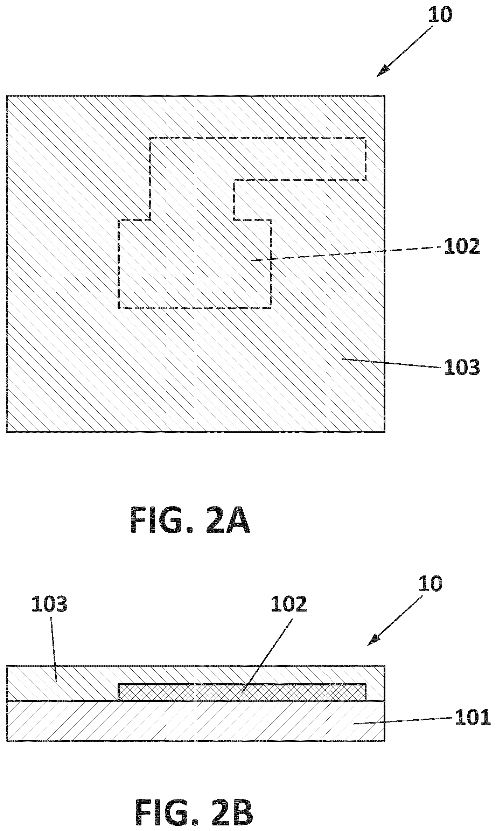

Referring to Figures 2A-2B, an insulating layer (a back insulating layer) 103 is deposited. The back insulating layer 103 may be a chemically inert electrical insulator. The back insulating layer 103 is made of a dielectric material, preferably an oxide dielectric material. The back insulating layer 103 is therefore a back dielectric layer (a back gate dielectric layer in the case of a GFET). The material of the back insulating layer 103 is selected to be compatible with different stages of the fabrication of the graphene device. Non-limiting examples of the dielectric materials used for the back insulating layer 103 are: SiO2, Al2O3, ZrO2, HfO2, HfSiO4, Ta2O5, La2O3, LaAlO3, Nb2O5, TiO2, BaTiO3, SrTiO3, CaCu3Ti4O12, GaN, TaN, Si3N4, ZrSiO4, Y2O3, CaO, MgO, BaO, WO3, MoO3, Sc2O3, Li2O and SrO.

The back insulating layer 103 may be deposited using a suitable deposition method, such as atomic layer deposition (ALD), chemical vapor deposition (CVD), Vapour Phase Epitaxy (VPE), sputtering or Molecular Beam Epitaxy (MBE). The suitability of deposition techniques may depend on the material to be deposited. For example, ALD may be suitable to deposit certain materials, while it may be unsuitable to deposit other materials. A skilled person in the art will select a suitable deposition technique for a selected insulating material, preferably inorganic oxide. The thickness of the back insulating layer 103 may be from several angstrom (10⁻¹⁰m) (for example, from 1Å) to several microns (for example, to 100µm). The thickness is selected taking into account different aspects.

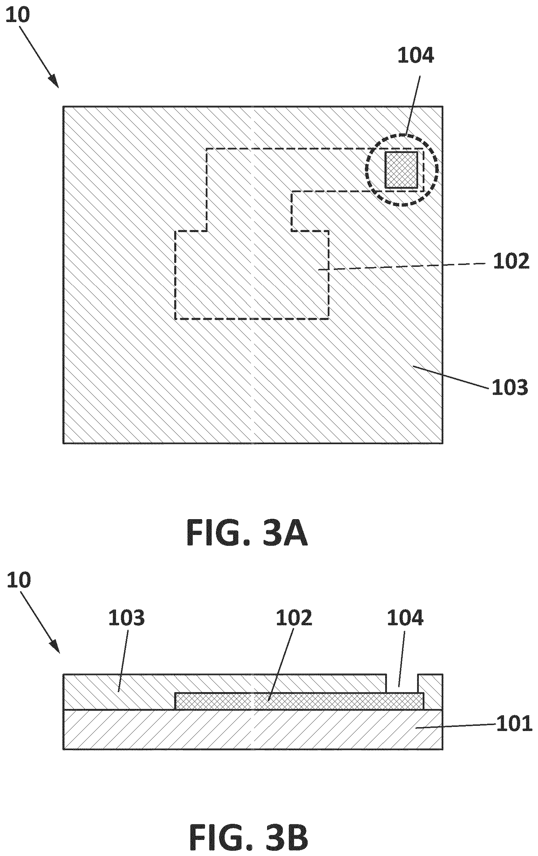

Referring to Figures 3A-3B, the back insulating layer 103 is patterned (etched) to expose the back contact layer 102 or portions thereof. In particular, the portion of the back contact layer 102 that will be the back contact of the manufactured device is exposed. For example, when the device is a GFET, the portion of the back gate layer 102 that will form the gate contact in the manufactured device, is exposed. The patterning may be done following different techniques. Because the back insulating layer 103 is preferably an oxide dielectric layer, the patterning may be performed using an etch process with good selectivity to the material of the back layer 102. In other words, the selected etch process removes a selected portion of the back insulating layer 103 without damaging the corresponding underlying portion of the back contact layer 102. The etch process may be dry etching or wet etching. Non-limiting examples of dry etching that may be used are RIE, DRIE or Bosch etch process. Non-limiting examples of wet etching that may be used are via an acid, such as H2SO4, HCl, H3PO4, HF, HI, CH3-COOH, C6H8O, or a base, such as NaOH, KOH, TMAH, LiOH. As a result of the selective etching process, a hollow portion 104 is defined in the back insulating layer 103, so that a portion of the back layer 102 is exposed in a region where a corresponding portion of dielectric layer 103 is removed.

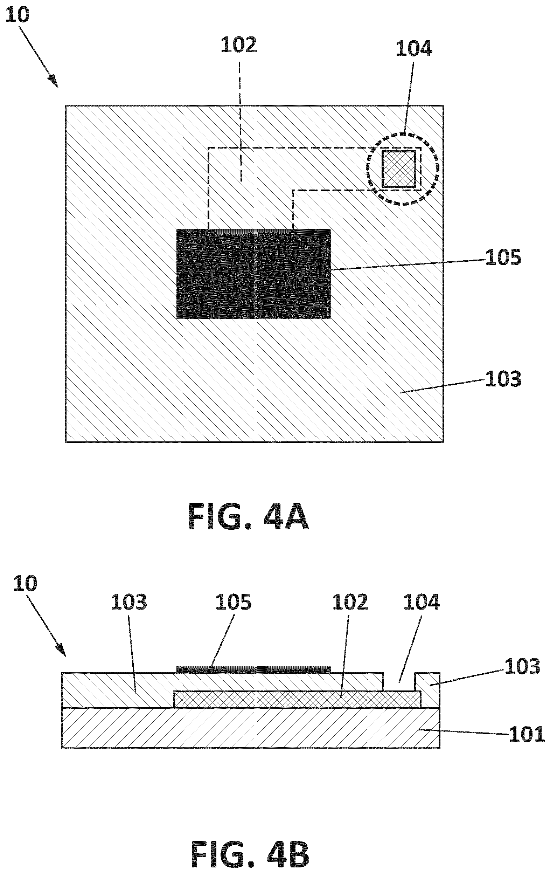

Referring to Figures 4A-4B, one or more graphene layers 105 are deposited, transferred or grown on the underlying structure. In particular, the one or more graphene layers 105 are deposited, transferred or grown on the back insulating layer 103, such as by transfer of CVD graphene layer(s). The deposition/transfer/growing process is out of the scope of the present invention. Any suitable conventional process of graphene deposition, transfer or growing can be used. From now on, the expression graphene layer is used to refer either to a single graphene layer or a multilayer of graphene. The graphene will be configured to serve as active channel or channels of the solid-state device, such as GFET.

The graphene layer 105 is patterned to define one or more structures, such as a channel region of a graphene device (e.g. a GFET) to be formed in subsequent manufacturing steps. In other words, the next step in the fabrication process is to pattern the graphene layer(s) with the layout of the channel(s). The graphene layer 105 may be patterned by applying a conventional technique, such as a lithographic step followed by an etching step. Non-limiting examples of semiconductor lithographic techniques that can be used for patterning the graphene layer(s) are X-ray lithography, electron-beam lithography, focused ion beam lithography, optical projection lithography, electron and ion projection lithography, nanoimprint lithography, proximity probe lithography, near-field optical lithography, contact lithography, immersion lithography or Extreme Ultraviolet Lithography. The patterns of the graphene channel(s) to be applied have been previously designed with computer-aided techniques, such as CAD software or the like.

The etching step may be a dry etching step via, for example, RIE, DRIE or plasma ashing, or a wet etching step. For example, etching of the graphene layer 105 may be performed using a multilayer etch mask (i.e. a photoresist) and plasma etching. The etching stage involves forming a multilayer etch mask (for example a photoresist), etching the graphene layer 105 and removing (stripping, for example) the multilayer etch mask. Techniques for forming an etching mask are known to those skilled in the art and thus are not described in more detail herein. In sum, the mask formed over the graphene layer(s) is used to etch away unwanted areas of the graphene layer(s), and an etch is then used to pattern the graphene and thereby define the channel(s). After etching, the mask is removed following a conventional suitable technique. The pattern of the graphene channel(s) is thus transferred. Other techniques for patterning the graphene layer 105 are possible.

Once the graphene channel(s) are defined on the graphene layer 105, a lithographic process is carried out to define the contact area(s) on which metal will be subsequently deposited. The metallization (metal deposition) can be made using a conventional lift-off process. The lift-off process is an additive technique in which a pattern of a target material (metal) is created on a surface using a mask material (e.g. resist, such as photoresist). Lift-off can be done by performing conventional photolithography before performing a metal deposition and then removing the applied photoresist, for example with a chemical etch.

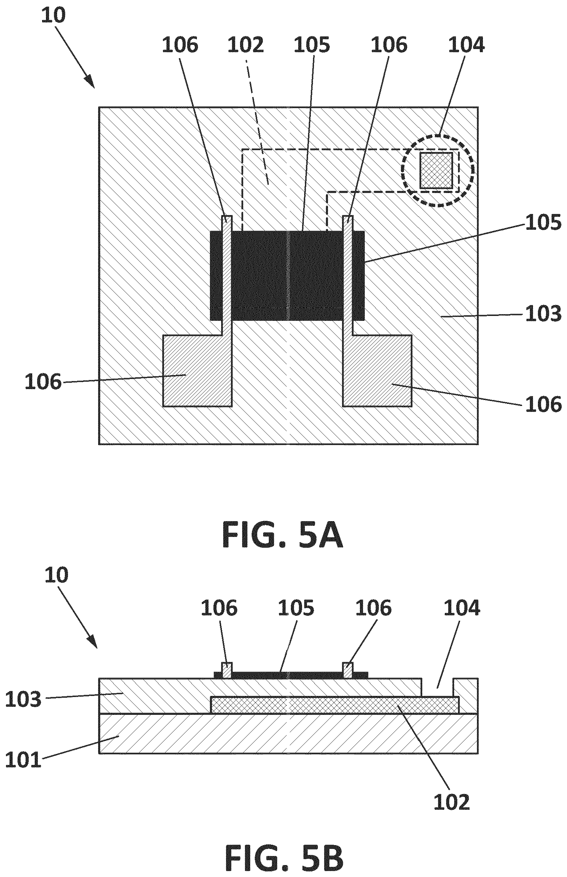

Then, referring to Figures 5A-5B, two top contacts 106 of electric conductive material are deposited on the defined areas of the graphene layer 105 following an established pattern, intended to become electric top contacts in the manufactured device. For example, when the device being manufactured is a GFET, contacts 106 correspond to source and drain top contacts of the GFET. The material of contacts 106 is preferably metallic. Non-limiting examples of metals used for the contacts 106 are: Au, Ti, TiN, W, Cr, Ni, Al, Cu, Pd, Pt, Co, Fe, poly-Si, doped-Si, Bi, Nb, Ag, Zn, and combinations of them. The contacts 106 may be deposited using a suitable deposition method, such as electron beam (ebeam) deposition or sputter deposition. The thickness of this layer or contact 106 may be from several nanometers (for example, from 1nm) to several microns (for example, to 100µm).

The fabrication process of the metal contacts 106 may be done as follows. The metal contacts are defined through semiconductor lithographic techniques over a graphene film, which can be patterned, for example following standard lithographic techniques. The patterns of the metallic depositions to be applied on graphene device have been previously designed with computer-aided techniques, such as CAD software or the like. The computer-aided design permits to define areas or regions on the surface of the die over which metallization is to be deposited. The metallization process is aimed at creating electrical contacts (two electrical contacts in the shown embodiment) in the graphene device: for example, but not limiting, one contact to enable a subsequent connection to an electric negative pole (of, for example, a voltage source) and another contact to enable a corresponding subsequent connection to an electric positive pole (of, for example, the voltage source).

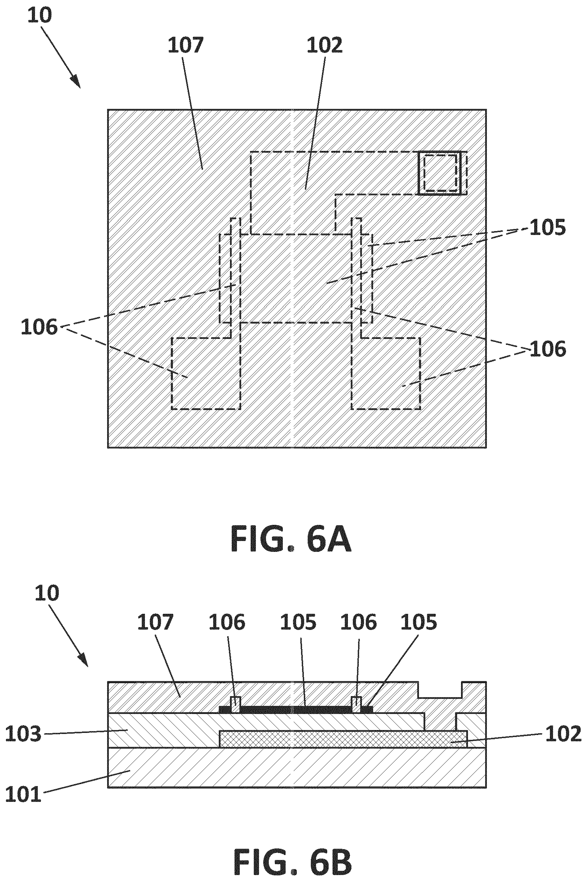

Referring to Figures 6A-6B, a second insulating layer 107 is deposited. Insulating layer 107 acts as a passivation layer for the contacts, in particular for the top contacts 106, since the back contact 102 is already passivated by the back insulating layer 103. Insulating layer 107 may be a chemically inert electrical insulator. The second insulating layer 107 is made of a dielectric material, preferably an oxide dielectric material. The second insulating layer 107 is therefore a dielectric layer. The material of the second insulating layer 107 is selected to be compatible with different stages of the fabrication of the graphene device. Non-limiting examples of the dielectric materials used for the second insulating layer 107 are: SiO2, Al2O3, ZrO2, HfO2, HfSiO4, Ta2O5, La2O3, LaAlO3, Nb2O5, TiO2, BaTiO3, SrTiO3, CaCu3Ti4O12, GaN, TaN, Si3N4, ZrSiO4, Y2O3, CaO, MgO, BaO, WO3, MoO3, Sc2O3, Li2O and SrO, but provided the material of the second insulating layer 107 is different from the material of which the first dielectric layer 103 is made. Particularly, both dielectric layers 103, 107 need to have very different selectivity to at least one etchant, in such a way that, when the second dielectric layer 107 is etched with said at least one etchant, for example to expose the graphene layer 105 for a subsequent processing step, such as the functionalization of the graphene, the first dielectric layer 103 is not damaged. In the context of the present invention, a first dielectric material is considered to have good selectivity to an etchant with respect to a second dielectric material when the etch rate of the first material is at least 2 times larger than the etch rate of the second material, such as at least 5 times larger, or at least 8 times larger, or at least 10 times larger. As a matter of example, Si (first material) has good selectivity to sulphuric acid H₂SO₄ (etchant) with respect to SiO₂ (second material) because when diluted in sulphuric acid H₂SO₄, Si dissolves 5 times quicker than SiO₂. The second insulating layer 107 may be deposited using a suitable deposition method, such as atomic layer deposition (ALD), chemical vapor deposition (CVD), Vapour Phase Epitaxy (VPE) or sputtering. The suitability of deposition techniques may depend on the material to be deposited. For example, ALD may be suitable to deposit certain materials, while it may be unsuitable to deposit other materials. The thickness of the second insulating layer 107 may be from several angstrom (10⁻¹⁰m) (for example, from 1Å) to several microns (for example, to 100µm). Like for the first dielectric layer 103, the thickness is selected taking into account different aspects.

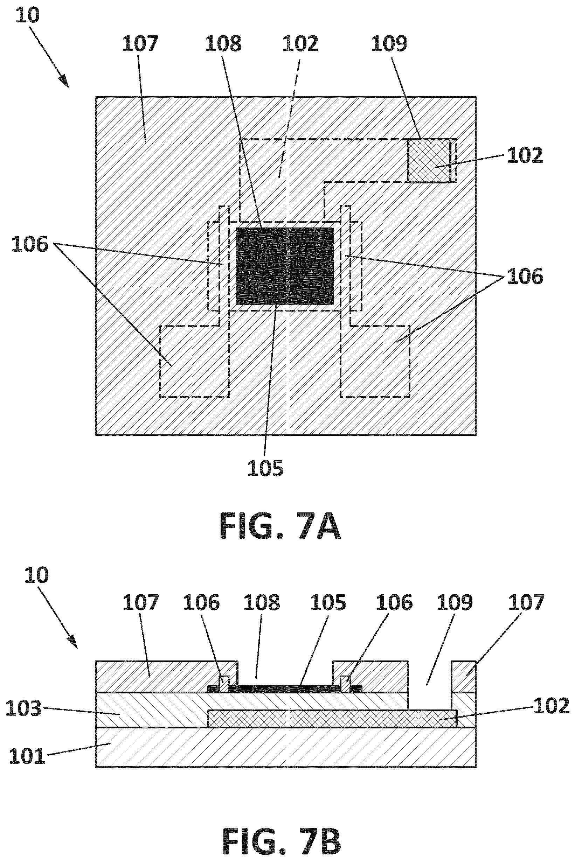

Referring to Figures 7A-7B, the second insulating layer 107 is selectively etched to expose the graphene layer 105 as required (for example, but not limiting, for a subsequent functionalization step). The etching may be done following different techniques. Because the second insulating layer 107 is preferably an oxide dielectric layer, the etching process needs to have good selectivity to the first dielectric layer 103, so that the first dielectric layer 103 is not damaged during this step. In other words, an etching process must be selected such that when applied, the second insulating layer 107 is etched (to expose the graphene channel 108 in Figure 7B) while the first insulating layer 103 is preserved. The etch process is preferably wet etching. Non-limiting examples of wet etching that may be used are an acid, such as H2SO4, HCl, H3PO4, HF, HI, CH3-COOH, C6H8O, or a base, such as NaOH, KOH, TMAH, LiOH. For example, when the first dielectric layer 103 is made of Al₂O₃ and the second dielectric layer 107 is made of SiO₂, the selected etchant used to etch the second dielectric layer 107 can be, for example, sulphuric acid or phosphoric acid, because Al₂O₃ has significantly different etch rate to sulphuric acid and to phosphoric acid than SiO₂. Any other etchant that also fulfills that the etch rate of the Al₂O₃ is significantly different (at least 2 times) form the etch rate of the SiO₂ can be used instead. As a result of the selective etching process, the back contact 102 and one or more portions of the graphene layer 105 become exposed for, for example, the functionalization step if the device is intended to be a sensor device, while the top contacts 106 remain encapsulated. In Figure 7B, references 108 and 109 denote hollow areas free of the second dielectric material.

The removal of the passivation (isolation) on the graphene channel, so that it can make contact, for example, with the sample, when the device is a biosensor, is made using a wet etching technique because a dry etching technique, such as Reactive Ion Etching (RIE), Deep-RIE (DRIE), plasma ashing and similar techniques, would damage the graphene channel. To overcome the drawbacks of dry etching techniques, a wet etching technique is preferably used. When a wet etching technique, usually an acid, is used to dissolve the dielectric (also referred to as isolation or passivation), the graphene acts as an etch stopper. However, inherent imperfections in graphene, such as micro- and nanoscopic tears in the graphene layer, can cause the etchant to diffuse through the dielectric layer, causing excessive leakage and thus rendering the back gate useless. Because these tears appear randomly and are not controllable, this problem could dramatically reduce the total device yield. This effect can be even more pronounced because gate dielectrics are usually much thinner than source and drain dielectrics because the capacitive coupling is enhanced in the former. These problems are overcome by selecting an etching process having good selectivity to the first dielectric layer 103, so that the first dielectric layer 103 is not damaged during this etching step.

In this text, the term "comprises" and its derivations (such as "comprising", etc.) should not be understood in an excluding sense, that is, these terms should not be interpreted as excluding the possibility that what is described and defined may include further elements, steps, etc.

In the context of the present invention, the term "approximately" and terms of its family (such as "approximate", etc.) should be understood as indicating values very near to those which accompany the aforementioned term. That is to say, a deviation within reasonable limits from an exact value should be accepted, because a skilled person in the art will understand that such a deviation from the values indicated is inevitable due to measurement inaccuracies, etc. The same applies to the terms "about" and "around" and "substantially".

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. A method of fabricating a graphene-based solid-state device, the method comprising:
disposing a layer of an electric conductive material (102) on a substrate (101);
depositing a first layer of an insulating material (103) on the layer of an electric conductive material (102), the first layer of an insulating material (103) being made of a first oxide dielectric material or any of GaN, TaN or Si3N4;
patterning the first layer of an insulating material (103) to expose at least a portion (104) of the layer of an electric conductive material (102);
disposing a graphene layer (105) on the first layer of an insulating material (103);
patterning the graphene layer (105) to define at least one channel region;
applying a lithographic process to define at least two contact areas in the graphene layer (105);
depositing one metallic contact (106) on each one of the at least two defined contact areas of the graphene layer (105);
depositing a second layer of an insulating material (107) on the stacked structure, the second layer of an insulating material (107) being made of a second oxide dielectric material or any of GaN, TaN or Si3N4 different of the first oxide dielectric material or any of GaN, TaN or Si3N4 of which the first layer of an insulating material (103) is made; and wherein the selectivity to at least one etchant of the first oxide dielectric material or any of GaN, TaN or Si3N4 of which the first layer of an insulating material (103) is made is different from the selectivity to said at least one etchant of the second oxide dielectric material or any of GaN, TaN or Si3N4 of which the second layer of an insulating material (107) is made;
selectively etching the second layer of an insulating material (107) to expose one or more portions of the graphene layer (105) and the at least one portion (104, 109) of the layer of an electric conductive material (102), while preserving the first layer of an insulating material (103).

2. The method of claim 1, wherein the first oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO.

3. The method of any one of claims 1 or 2, wherein the second oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO, provided that the second oxide dielectric material is different of the first oxide dielectric material and the selectivity to at least one etchant of the first oxide dielectric material is different from the selectivity to said at least one etchant of the second oxide dielectric material.

4. The method of any one of claims 1-3, wherein prior to disposing the at least one graphene layer (105) on the first layer of an insulating material (103), the substrate (101) is cleaned to remove impurities and increase hydrophilicity.

5. The method of any one of claims 1-4, wherein the layer of an electric conductive material (102) and/or the at least one metallic contact (106) are made of at least one of: Titanium (Ti), Nickel (Ni), Gold (Au), Palladium (Pd), Cobalt (Co), Chromium (Cr), Aluminum (Al), Tungsten (W), TaN, (Tantalum Nitride), TiN (Titanium Nitride), Silicon (Si), doped Silicon (doped Si), poly-silicon (poly-Si), Cobalt monosilicide (CoSi), Platinum (Pt), Copper (Cu), Silver (Ag), Lead (Pb), Iron (Fe), Co/Fe alloy, and combinations/alloys of these materials.

6. A graphene-based solid-state device comprising a substrate (101), at least one graphene channel and at least three contacts (102, 106), the graphene-based solid-state device comprising:
a layer of an electric conductive material (102) disposed on a substrate (101), the layer of electric conductive material defining a back electrical contact ();
a first insulating material (103) covering the layer of electric conductive material (102) except on the area (109) defining the back electrical contact, the first insulating material (103) being made of a first oxide dielectric material or any of GaN, TaN or Si3N4;
a graphene layer (105) disposed on the first insulating material (103), the graphene layer defining the graphene channel;
at least two top electrical contacts (106) disposed on the graphene layer (105);
a second layer of an insulating material (107) covering part of the graphene layer (105) while leaving part thereof (108) and at least one portion (104, 109) of the layer of an electroconductive material (102) exposed, and covering the first insulating material (103), the second insulating material (107) being made of a second oxide dielectric material or any of GaN, TaN or Si3N4 different of the first oxide dielectric material or any of GaN, TaN or Si3N4; and wherein the selectivity to at least one etchant of the first oxide dielectric material or any of GaN, TaN or Si3N4 of which the first insulating layer (103) is made is different from the selectivity to said at least one etchant of the second oxide dielectric material or any of GaN, TaN or Si3N4 of which the second insulating layer (107) is made.

7. The device of claim 6, wherein the first oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO.

8. The device of any one of claims 6 or 7, wherein the second oxide dielectric material is selected from the following group: SiO2, Al2O3, ZrO2, HfO2, HfSiO4, Ta2O5, La2O3, LaAlO3, Nb2O5, TiO2, BaTiO3, SrTiO3, CaCu3Ti4O12, ZrSiO4, Y2O3, CaO, MgO, BaO, WO3, MoO3, Sc2O3, Li2O and SrO, provided that the second oxide dielectric material is different of the first oxide dielectric material and the selectivity to at least one etchant of the first oxide dielectric material is different from the selectivity to said at least one etchant of the second oxide dielectric material.

## Patentansprüche

1. Ein Verfahren zur Herstellung einer graphenbasierten Festkörpervorrichtung, wobei das Verfahren das:
- Anordnen einer Schicht aus einem elektrisch leitfähigen Material (102) auf einem Substrat (101),
- Aufbringen einer ersten Schicht aus einem Isolationsmaterial (103) auf die Schicht aus einem elektrisch leitfähigen Material(102), wobei die erste Schicht aus einem Isolationsmaterial (103) aus einem ersten dielektrischen Oxidmaterial oder einem von GaN, TaN oder Si₃N₄ hergestellt ist,
- Versehen der ersten Schicht aus einem Isolationsmaterial (103) mit einem Muster, um wenigstens einen Teil (104) der Schicht aus einem elektrisch leitfähigen Material (102) freizulegen,
- Anordnen einer Graphenschicht (105) auf der ersten Schicht aus einem Isolationsmaterial (103),
- Versehen der Graphenschicht (105) mit einem Muster, um mindestens einen Kanalbereich zu bilden,
- Durchführen eines lithographischen Vorgangs, um mindestens zwei Kontaktflächen auf der Graphenschicht (105) zu bilden,
- Aufbringen eines Metallkontakts (106) auf jeder der mindestens zwei gebildeten Kontaktflächen der Graphenschicht (105),
- Aufbringen einer zweiten Schicht aus einem Isolationsmaterial (107) auf die Schichtstruktur, wobei die zweite Schicht aus einem Isolationsmaterial (107) aus einem zweiten dielektrischen Oxidmaterial oder einem von GaN, TaN oder Si₃N₄ hergestellt ist, das sich von dem ersten dielektrischen Oxidmaterial oder einem von GaN, TaN oder Si₃N₄, aus welchem die erste Schicht aus einem Isolationsmaterial (103) hergestellt ist, unterscheidet, und wobei die Selektivität gegenüber mindestens einem Mittel zum Ätzen des ersten dielektrischen Oxidmaterials oder eines von GaN, TaN oder Si₃N₄, aus welchem die erste Schicht aus einem Isolationsmaterial (103) hergestellt ist, sich von der Selektivität gegenüber dem mindestens einen Mittel zum Ätzen des zweiten dielektrischen Oxidmaterials oder eines von GaN, TaN oder Si₃N₄, aus welchem die zweite Schicht aus einem Isolationsmaterial (107) hergestellt ist, unterscheidet, und
- selektives Ätzen der zweiten Schicht aus einem Isolationsmaterial (107), um einen oder mehrere Teile der Graphenschicht (105) und den mindestens einen Teil (104, 109) der Schicht aus einem elektrisch leitfähigen Material (102) freizulegen, wobei die erste Schicht aus einem Isolationsmaterial (103) erhalten bleibt,
umfasst.

2. Das Verfahren nach Anspruch 1, wobei das erste dielektrische Oxidmaterial aus der Gruppe aus SiO₂, Al₂O₃, ZrO₂, HfO₂, HfSiO₄, Ta₂O₅, La₂O₃, LaAlO₃, Nb₂O₅, TiO₂, BaTiO₃, SrTiO₃, CaCu₃Ti₄O₁₂, ZrSiO₄, Y₂O₃, CaO, MgO, BaO, WO₃, MoO₃, Sc₂O₃, Li₂O und SrO ausgewählt wird.

3. Das Verfahren nach Anspruch 1 oder 2, wobei das zweite dielektrische Oxidmaterial aus der Gruppe aus SiO₂, Al₂O₃, ZrO₂, HfO₂, HfSiO₄, Ta₂O₅, La₂O₃, LaAlO₃, Nb₂O₅, TiO₂, BaTiO₃, SrTiO₃, CaCu₃Ti₄O₁₂, ZrSiO₄, Y₂O₃, CaO, MgO, BaO, WO₃, MoO₃, Sc₂O₃, Li₂O und SrO ausgewählt wird, unter der Voraussetzung, dass das zweite dielektrische Oxidmaterial sich von dem ersten dielektrischen Oxidmaterial unterscheidet und die Selektivität gegenüber mindestens einem Mittel zum Ätzen des ersten dielektrischen Oxidmaterials sich von der Selektivität gegenüber dem mindestens einen Mittel zum Ätzen des zweiten dielektrischen Oxidmaterials unterscheidet.

4. Das Verfahren nach einem der Ansprüche 1 bis 3, wobei vor dem Anordnen der mindestens einen
Graphenschicht (105) auf der ersten Schicht aus einem Isolationsmaterial (103) das Substrat (101) gereinigt wird, um Verunreinigungen zu entfernen und die Hydrophilie zu erhöhen.

5. Das Verfahren nach einem der Ansprüche 1 bis 4, wobei die Schicht aus einem elektrisch leitfähigen Material (102) und/oder der wenigstens eine Metallkontakt (106) aus mindestens einem von Titan (Ti), Nickel (Ni), Gold (Au), Palladium (Pd), Cobalt (Co), Chrom (Cr), Aluminium (Al), Wolfram (W), TaN, (Tantalnitrid), TiN (Titannitrid), Silicium (Si), dotiertem Silicium (dotiertem Si), Polysilicium (Poly-Si), Cobaltmonosilicid (CoSi), Platin (Pt), Kupfer (Cu), Silber (Ag), Blei (Pb), Eisen (Fe), Co/Fe-Legierung und Kombinationen/Legierungen dieser Materialien hergestellt sind.

6. Eine graphenbasierte Festkörpervorrichtung, die ein Substrat (101), mindestens einen Graphenkanal und mindestens drei Kontakte (102, 106) umfasst, wobei die graphenbasierte Festkörpervorrichtung:
- eine Schicht aus einem elektrisch leitfähigen Material (102), die auf einem Substrat (101) angeordnet ist, wobei die Schicht aus einem elektrisch leitfähigen Material einen unteren elektrischen Kontakt () bildet,
- ein erstes Isolationsmaterial (103), das die Schicht aus einem elektrisch leitfähigen Material (102), außer der Fläche (109), die den unteren elektrischen Kontakt bildet, bedeckt, wobei das erste Isolationsmaterial (103) aus einem ersten dielektrischen Oxidmaterial oder einem von GaN, TaN oder Si₃N₄ hergestellt ist,
- eine Graphenschicht (105), die auf dem ersten Isolationsmaterial (103) angeordnet ist, wobei die Graphenschicht den Graphenkanal bildet,
- mindestens zwei obere elektrische Kontakte (106), die auf der Graphenschicht (105) angeordnet sind, und
- eine zweite Schicht aus einem Isolationsmaterial (107), die einen Teil der Graphenschicht (105), wobei ein Teil (108) von dieser und mindestens ein Teil (104, 109) der Schicht aus einem elektrisch leitfähigen Material (102) freigelegt bleibt, und das erste Isolationsmaterial (103) bedeckt, wobei das zweite Isolationsmaterial (107) aus einem zweiten dielektrischen Oxidmaterial oder einem von GaN, TaN oder Si₃N₄ hergestellt ist, das sich von dem ersten dielektrischen Oxidmaterial oder einem von GaN, TaN oder Si₃N₄ unterscheidet, und wobei die Selektivität gegenüber mindestens einem Mittel zum Ätzen des ersten dielektrischen Oxidmaterials oder eines von GaN, TaN oder Si₃N₄, aus welchem die erste Isolationsschicht (103) hergestellt ist, sich von der Selektivität gegenüber dem mindestens einen Mittel zum Ätzen des zweiten dielektrischen Oxidmaterials oder eines von GaN, TaN oder Si₃N₄, aus welchem die zweite Isolationsschicht (107) hergestellt ist, unterscheidet,
umfasst.

7. Die Vorrichtung nach Anspruch 6, wobei das erste dielektrische Oxidmaterial aus der Gruppe aus SiO₂, Al₂O₃, ZrO₂, HfO₂, HfSiO₄, Ta₂O₅, La₂O₃, LaAlO₃, Nb₂O₅, TiO₂, BaTiO₃, SrTiO₃, CaCu₃Ti₄O₁₂, ZrSiO₄, Y₂O₃, CaO, MgO, BaO, WO₃, MoO₃, Sc₂O₃, Li₂O und SrO ausgewählt ist.

8. Die Vorrichtung nach Anspruch 6 oder 7, wobei das zweite dielektrische Oxidmaterial aus der Gruppe aus SiO₂, Al₂O₃, ZrO₂, HfO₂, HfSiO₄, Ta₂O₅, La₂O₃, LaAlO₃, Nb₂O₅, TiO₂, BaTiO₃, SrTiO₃, CaCu₃Ti₄O₁₂, ZrSiO₄, Y₂O₃, CaO, MgO, BaO, WO₃, MoO₃, Sc₂O₃, Li₂O und SrO ausgewählt ist, unter der Voraussetzung, dass das zweite dielektrische Oxidmaterial sich von dem ersten dielektrischen Oxidmaterial unterscheidet und die Selektivität gegenüber mindestens einem Mittel zum Ätzen des ersten dielektrischen Oxidmaterials sich von der Selektivität gegenüber dem mindestens einen Mittel zum Ätzen des zweiten dielektrischen Oxidmaterials unterscheidet.

## Revendications

1. Méthode de fabrication d'un dispositif à l'état solide à base de graphène, la méthode comprenant :
le dépôt d'une couche d'un matériau électroconducteur (102) sur un substrat (101) ;
le dépôt d'une première couche d'un matériau isolant (103) sur la couche d'un matériau électroconducteur (102), la première couche d'un matériau isolant (103) étant faite d'un premier matériau diélectrique d'oxyde ou de l'un quelconque parmi GaN, TaN ou Si3N4 ;
la formation de motifs sur la première couche d'un matériau isolant (103) pour exposer au moins une portion (104) de la couche d'un matériau électroconducteur (102) ;
le dépôt d'une couche de graphène (105) sur la première couche d'un matériau isolant (103) ;
la formation de motifs sur la couche de graphène (105) pour définir au moins une région de canal ;
l'application d'un procédé lithographique pour définir au moins deux zones de contact dans la couche de graphène (105) ;
le dépôt d'un contact métallique (106) sur chacune des au moins deux zones de contact définies de la couche de graphène (105) ;
le dépôt d'une deuxième couche d'un matériau isolant (107) sur la structure empilée, la deuxième couche d'un matériau isolant (107) étant faite d'un deuxième matériau diélectrique d'oxyde ou de l'un quelconque parmi GaN, TaN ou Si3N4 différent du premier matériau diélectrique d'oxyde ou de l'un quelconque parmi GaN, TaN ou Si3N4 dont la première couche d'un matériau isolant (103) est faite ; et dans laquelle la sélectivité pour au moins un agent de gravure du premier matériau diélectrique d'oxyde ou de l'un quelconque parmi GaN, TaN ou Si3N4 dont la première couche d'un matériau isolant (103) est faite est différente de la sélectivité pour ledit au moins un agent de gravure du deuxième matériau diélectrique d'oxyde ou de l'un quelconque parmi GaN, TaN ou Si3N4 dont la deuxième couche d'un matériau isolant (107) est faite ;
la gravure sélective de la deuxième couche d'un matériau isolant (107) pour exposer une ou plusieurs portions de la couche de graphène (105) et la au moins une portion (104, 109) de la couche d'un matériau électroconducteur (102), tout en préservant la première couche d'un matériau isolant (103).

2. Méthode selon la revendication 1, dans laquelle le premier matériau diélectrique d'oxyde est choisi dans le groupe suivant : SiO2, Al2O3, ZrO2, HfO2, HfSiO4, Ta2O5, La2O3, LaAlO3, Nb2OS, TiO2, BaTiO3, SrTiO3, CaCu3Ti4O12, ZrSiO4, Y2O3, CaO, MgO, BaO, WO3, MoO3, Sc2O3, Li2O et SrO.

3. Méthode selon l'une quelconque des revendications 1 ou 2, dans laquelle le deuxième matériau diélectrique d'oxyde est choisi dans le groupe suivant : SiO2, Al2O3, ZrO2, HfO2, HfSiO4, Ta2O5, La2O3, LaAlO3, Nb2OS, TiO2, BaTiO3, SrTiO3, CaCu3Ti4O12, ZrSiO4, Y2O3, CaO, MgO, BaO, WO3, MoO3, Sc2O3, Li2O et SrO, à condition que le deuxième matériau diélectrique d'oxyde soit différent du premier matériau diélectrique d'oxyde et que la sélectivité pour au moins un agent de gravure du premier matériau diélectrique d'oxyde soit différente de la sélectivité pour ledit au moins un agent de gravure du deuxième matériau diélectrique d'oxyde.

4. Méthode selon l'une quelconque des revendications 1 à 3, dans laquelle, avant de déposer la au moins une couche de graphène (105) sur la première couche d'un matériau isolant (103), le substrat (101) est nettoyé pour éliminer les impuretés et augmenter l'hydrophilie.

5. Méthode selon l'une quelconque des revendications 1 à 4, dans laquelle la couche d'un matériau électroconducteur (102) et/ou le au moins un contact métallique (106) sont faits d'au moins un élément parmi : le titane (Ti), le nickel (Ni), l'or (Au), le palladium (Pd), le cobalt (Co), le chrome (Cr), l'aluminium (Al), le tungstène (W), le TaN (nitrure de tantale), le TiN (nitrure de titane), le silicium (Si), le silicium dopé (Si dopé), le polysilicium (poly-Si), le monosiliciure de cobalt (CoSi), le platine (Pt), le cuivre (Cu), l'argent (Ag), le plomb (Pb), le fer (Fe), l'alliage Co/Fe et des combinaisons/alliages de ces matériaux.

6. Dispositif à l'état solide à base de graphène comprenant un substrat (101), au moins un canal de graphène et au moins trois contacts (102, 106), le dispositif à l'état solide à base de graphène comprenant :
une couche d'un matériau électroconducteur (102) disposée sur un substrat (101), la couche du matériau électroconducteur définissant un contact électrique arrière () ;
un premier matériau isolant (103) recouvrant la couche du matériau électroconducteur (102) sauf sur la zone (109) définissant le contact électrique arrière, le premier matériau isolant (103) étant fait d'un premier matériau diélectrique d'oxyde ou de l'un quelconque parmi GaN, TaN ou Si3N4 ;
une couche de graphène (105) disposée sur le premier matériau isolant (103), la couche de graphène définissant le canal de graphène ;
au moins deux contact électriques supérieurs (106) disposés sur la couche de graphène (105) ;
une deuxième couche d'un matériau isolant (107) recouvrant une partie de la couche de graphène (105) tout en laissant une partie de celle-ci (108) et au moins une portion (104, 109) de la couche d'un matériau électroconducteur (102) exposée, et recouvrant le premier matériau isolant (103), le deuxième matériau isolant (107) étant fait d'un deuxième matériau diélectrique d'oxyde ou de l'un quelconque parmi GaN, TaN ou Si3N4 différent du premier matériau diélectrique d'oxyde ou de l'un quelconque parmi GaN, TaN ou Si3N4 ; et dans lequel la sélectivité pour au moins un agent de gravure du premier matériau diélectrique d'oxyde ou de l'un quelconque parmi GaN, TaN ou Si3N4 dont la première couche isolante (103) est faite est différente de la sélectivité pour ledit au moins un agent de gravure du deuxième matériau diélectrique d'oxyde ou de l'un quelconque parmi GaN, TaN ou Si3N4 dont la deuxième couche isolante (107) est faite.

7. Dispositif selon la revendication 6, dans lequel le premier matériau diélectrique d'oxyde est choisi dans le groupe suivant : SiO2, Al2O3, ZrO2, HfO2, HfSiO4, Ta2O5, La2O3, LaAlO3, Nb2OS, TiO2, BaTiO3, SrTiO3, CaCu3Ti4O12, ZrSiO4, Y2O3, CaO, MgO, BaO, WO3, MoO3, Sc2O3, Li2O et SrO.

8. Dispositif selon l'une quelconque des revendications 6 ou 7, dans lequel le deuxième matériau diélectrique d'oxyde est choisi dans le groupe suivant : SiO2, Al2O3, ZrO2, HfO2, HfSiO₄, Ta2O5, La2O3, LaAlO3, Nb2OS, TiO2, BaTiO3, SrTiO3, CaCu3Ti4O12, ZrSiO4, Y2O3, CaO, MgO, BaO, WO3, MoO3, Sc2O3, Li2O et SrO, à condition que le deuxième matériau diélectrique d'oxyde soit différent du premier matériau diélectrique d'oxyde et que la sélectivité pour au moins un agent de gravure du premier matériau diélectrique d'oxyde soit différente de la sélectivité pour ledit au moins un agent de gravure du deuxième matériau diélectrique d'oxyde.
